# EUROPÄISCHE PATENTSCHRIFT

(11) **EP 1 883 141 B1**
(45) Veröffentlichungstag und Bekanntmachung des Hinweises auf die Patenterteilung: **24.05.2017**
(21) Anmeldenummer: 07013822.7
(22) Anmeldetag: 13.07.2007
(51) Int. Cl.: H01S 5/343, H01L 33/06, H01L 33/32, H01L 33/04, H01S 5/042, H01S 5/20, H01S 5/30, H01S 5/32

(54) **LD oder LED mit Übergitter-Mantelschicht**
LD or LED with superlattice cladding layer
LD ou DEL avec une couche de revêtement superréseau

(30) Priorität: 27.07.2006 DE 102006034820; 29.09.2006 DE 102006046237
(43) Veröffentlichungstag der Anmeldung: 30.01.2008
(73) Patentinhaber: OSRAM Opto Semiconductors GmbH, 93055 Regensburg (DE)
(72) Erfinder: Eichler, Christoph, 93105 Tegernheim (DE); Lell, Alfred, 93142 Maxhütte-Haidhof (DE); Miler, Andreas, 86916 Kaufering (DE); Schillgalies, Marc, 93047 Regensburg (DE)
(74) Vertreter: Epping - Hermann - Fischer

(56) Entgegenhaltungen:
- EP-A- 1 670 106
- US-A- 4 839 899
- US-A1- 2003 197 188
- US-B1- 6 175 123
- KAUSER M ET AL: "Enhanced vertical transport in p-type AlGaN/GaN superlattices" APPLIED PHYSICS LETTERS, AIP, AMERICAN INSTITUTE OF PHYSICS, MELVILLE, NY, US, Bd. 85, Nr. 22, 29. November 2004 (2004-11-29), Seiten 5275-5277, XP012063613 ISSN: 0003-6951
- KAUSER M ET AL: "Optimization of conductivity in p-type GaN/InGaN-graded superlattices" JOURNAL OF APPLIED PHYSICS, AMERICAN INSTITUTE OF PHYSICS. NEW YORK, US, Bd. 97, Nr. 8, 12. April 2005 (2005-04-12), Seiten 83715-83715, XP012071085 ISSN: 0021-8979
- TING GANG ZHU ET AL: "AlGaN-GaN UV Light-Emitting Diodes Grown on SiC by Metal-Organic Chemical Vapor Deposition" IEEE JOURNAL OF SELECTED TOPICS IN QUANTUM ELECTRONICS, IEEE SERVICE CENTER, PISCATAWAY, NJ, US, Bd. 8, Nr. 2, März 2002 (2002-03), XP011066127 ISSN: 1077-260X
- NAKAMURA S ET AL: "Present status of InGaN/GaN/AlGaN-based laser diodes" JOURNAL OF CRYSTAL GROWTH, NORTH-HOLLAND PUBLISHING, AMSTERDAM, NL, Bd. 189-190, 15. Juni 1998 (1998-06-15), Seiten 820-825, XP004148631 ISSN: 0022-0248

## Beschreibung

Diese Patentanmeldung beansprucht die Priorität der deutschen Patentanmeldungen 10 2006 034 820.6 und 10 2006 046 237.8.

Die Erfindung betrifft ein optoelektronisches Bauelement mit einer Halbleiter-Schichtstruktur, die ein Übergitter aus gestapelten Schichten eines ersten und mindestens eines zweiten Typs, wobei die Schichten des ersten Typs und des mindestens einen zweiten Typs III-V Verbindungshalbleiter sind und sich im Übergitter benachbarte Schichten unterschiedlichen Typs in der Zusammensetzung in mindestens einem Element unterscheiden.

Verglichen mit einer Schicht gleicher Dicke aus nur einem Material einer Zusammensetzung haben Übergitter mit gestapelten Schichten verschiedenen Typs unterschiedliche elektrische, optische und epitaktische Eigenschaften. Insbesondere kann bei geeigneter Zusammensetzung und Dotierung ein Übergitter aus alternierend gestapelten p-dotierten Gallium-Nitrid- (GaN) und p-dotierten Aluminium-Gallium-Nitrid- (AlGaN) Schichten eine höhere Leitfähigkeit aufweisen als eine p-dotierte reine GaN- oder AlGaN-Schicht der gleichen Dicke. Aufgrund dieser Eigenschaften finden Übergitter vielfach Verwendung in elektronischen und optoelektronischen Bauteilen.

Optoelektronische Bauelemente mit einer Halbleiter-Schichtstruktur, die ein Übergitter enthält, werden zum Beispiel in den Druckschriften EP 1 670 106 A1 und US 2003/0197188 A1 beschrieben.

Aufgabe der Erfindung ist es, ein optoelektronisches Bauelement mit einer Halbleiter-Schichtstruktur mit Übergitter der eingangs genannten Art mit verbesserten elektrischen und optischen Eigenschaften zu schaffen.

Diese Aufgabe wird gemäß Patentanspruch 1 durch ein optoelektronisches Bauelement gelöst, das eine aktive Schicht aufweist, wobei die aktive Schicht zwischen Wellenleiterschichten angeordnet ist, zwischen der aktiven Schicht und einer der Wellenleiterschichten eine Barriereschicht angeordnet ist, und jeweils auf der der aktiven Schicht abgewandten Seite der Wellenleiterschichten eine Mantelschicht angeordnet ist. Zumindest eine Mantelschicht umfasst eine Halbleiter-Schichtstruktur, die ein Übergitter aus gestapelten Schichten eines ersten und mindestens eines zweiten Typs umfasst, wobei die Schichten des ersten Typs und des mindestens einen zweiten Typs alternierend gestapelte InₓAl_{y}Ga_{1-x-y}N- und In_{w}Al_{z}Ga_{1-w-z}N-Schichten mit 0 ≤ x, y, w, z ≤ 1 und x + y ≤ 1 und w + z ≤ 1 sind. Im Übergitter unterscheiden sich benachbarte Schichten unterschiedlichen Typs in der Zusammensetzung in mindestens einem Element, wobei zumindest zwei Schichten eines gleichen Typs einen unterschiedlichen Gehalt an dem mindestens einen Element aufweisen. Der Gehalt an dem mindestens einen Element der Schichten zumindest eines Typs ist innerhalb des Übergitters gradiert. Die Schichten des Übergitters enthalten Dotierstoffe in vorgegebenen Konzentrationen, wobei das Übergitter Schichten aufweist, die mit Mg in unterschiedlichen Konzentrationen dotiert sind. Der Gehalt an dem mindestens einen Element im Inneren des Übergitters hat einen Maximalwert, der nicht in der Mitte des Übergitters liegt.

Auf diese Weise können die elektrischen, optischen und epitaktischen Eigenschaften des Übergitters bestmöglich an gegebene Erfordernisse angepasst werden. Dieses gilt insbesondere für epitaktische Randbedingungen, an die das Übergitter angepasst werden kann.

Häufig sind die gegebenen Erfordernisse an das Übergitter nicht über seine gesamte Dicke gleich, beispielsweise weil physikalische Größen, wie eine elektrische oder optische Feldstärke, die Einfluss auf die Erfordernisse haben, ebenfalls über die Dicke des Übergitters nicht konstant sind.

Beispielsweise kann die Zusammensetzung innerhalb der Schichten eines Typs sowohl Einfluss auf den Brechungsindex und damit auf eine optische Wellenführung, als auch auf die Größe der Bandlücke und damit auf optische Absorptionsverluste, als auch auf Gitterstruktur und/oder -konstante und damit auf Verspannungen, die das Übergitter auf angrenzende Schichten ausübt, haben. Dabei kann die Abhängigkeit der Größen von dem Gehalt an einem Element bezüglich gewünschter Eigenschaften des Übergitters beispielsweise derart gegenläufig sein, dass ein hoher Gehalt zwar die Wellenführung durch das Übergitter vorteilhaft beeinflusst und/oder optische Absorptionsverluste vorteilhaft verringert, aber auch Verspannungen angrenzender Schichten nachteilig verstärkt.

Eine gleiche Zusammensetzung für alle Schichten eines Typs kann in einem solchen Fall bestenfalls ein Kompromiss zwischen erreichbaren Vorteilen und in Kauf zu nehmenden Nachteilen darstellen. Durch die innerhalb eines Schichtentyps variierende Zusammensetzung, durch einen gradierten Gehalt an dem mindestens einem Element und durch unterschiedliche Dotierstoffe können räumlich unterschiedlichen Anforderungen an das Übergitter dagegen Rechnung getragen werden. Insbesondere wird für Schichten im Randbereich des Übergitters, die bezüglich der Verspannungen auf angrenzende Schichten maßgeblich sind, eine andere Zusammensetzung und/oder andere Dotierstoffe vorgesehen, als für Schichten im mittleren Bereich des Übergitters, die wegen der größeren räumlichen Ausdehnung des mittleren Bereichs für die Wellenführung maßgeblich sind.

Grundsätzlich wird als Übergitter eine Struktur bezeichnet, die eine Periodizität aufweist, deren Periodenlänge größer ist als die Gitterkonstanten eingesetzter Materialien. Im Rahmen der Anmeldung wird als Übergitter eine Folge gestapelter Schichten bezeichnet, bei der sich in einer Richtung senkrecht zu den Grenzflächen zwischen den Schichten, also z.B. in Aufwachsrichtung der Schichten, eine Schichtabfolge, umfassend mindestens zwei Schichten unterschiedlichen Typs, wiederholt. Ein Übergitter in diesem Sinne ist beispielsweise durch eine Folge alternierend gestapelter Schichten verschiedener Typen gegeben, wobei alternierend so zu verstehen ist, dass sich zwei oder mehr Schichten abwechseln. Innerhalb der sich wiederholenden Schichtabfolge kann dabei ein Typ durch mehr als eine Schicht vertreten sein. Beispiele für derartige Übergitter sind durch die folgenden Schichtenfolgen gegeben: "ab|ab|ab|...", "abc|abc|abc|...", "abcb|abcb|..." und "ababababc|ababababc|...", wobei a, b und c jeweils Schichten eines Typs angeben und die sich wiederholende Schichtenabfolge durch das Trennzeichen "|" verdeutlicht ist.

Im Rahmen der Anmeldung ist die Zusammensetzung einer Schicht durch in der Schicht enthaltene Elemente sowie ihre nominelle (d.h. im Rahmen der Genauigkeit der Kompositionsüberwachung während oder nach dem Wachstumsprozess) Stöchiometrie definiert, wobei Dotierstoffe und Verunreinigungen nicht mitberücksichtigt werden. Die Stöchiometrie ist durch den Gehalt (Anteil) der einzelnen Elemente in der Schicht gegeben.

Der Typ einer Schicht ist durch die Zusammensetzung der Schicht gegeben, wobei das jedoch nicht zwangsläufig bedeutet, dass alle Schichten eines Typs die gleiche Zusammensetzung aufweisen. Die Zusammensetzung der Schichten eines Typs kann innerhalb des Übergitters in vorgegebener Weise variieren, z.B. indem die Konzentration eines Elements der Schichten eines Typs von Schicht zu Schicht dieses Typs anwächst. Im Übergitter benachbarte Schichten unterschiedlichen Typs unterscheiden sich jedoch in ihrer Zusammensetzung in mindestens einem Element.

Bei der Halbleiter-Schichtstruktur weist das Übergitter alternierend gestapelte InₓAl_{y}Ga_{1-x-y}N- und In_{w}Al_{z}Ga_{1-w-z}N-Schichten mit 0≤x,y,w,z<1 und x+y≤1 und w+z≤1 auf. Dieses Materialsystem ist zum einen von großer technologischer Bedeutung und zum anderen kann in diesem System eine vorteilhafte Leitfähigkeitserhöhung insbesondere der Löcherleitung durch den Einsatz eines Übergitters beobachtet werden.

Gemäß einer weiteren vorteilhaften Ausgestaltung der Halbleiter-Schichtstruktur ist den einzelnen Schichten des Übergitters eine vertikale Position innerhalb der Halbleiter-Schichtstruktur zugeordnet und der Gehalt an dem mindestens einen Element in einer Schicht ist in vorgegebener Weise abhängig von ihrer vertikalen Position innerhalb der Halbleiter-Schichtstruktur. Auf diese Weise kann das Übergitter und seine Eigenschaften bestmöglich an räumlich unterschiedliche Anforderungen an das Übergitter angepasst werden.

Gemäß weiterer vorteilhafter Ausgestaltungen ist die Abhängigkeit des Gehalts an dem mindestens einen Element von der vertikalen Position entweder für alle Schichten durch eine gemeinsame Funktion vorgegeben oder sie ist für Schichten des ersten Typs durch eine erste Funktion und für Schichten des zweiten Typs durch mindestens eine zweite Funktion vorgegeben. Besonders bevorzugt ist dabei die erste und/oder die mindestens eine zweite und/oder die gemeinsame Funktion eine Stufenfunktion oder eine monoton steigende/fallende Funktion oder eine lineare Funktion oder eine Polynomfunktion oder eine Wurzelfunktion oder eine exponentielle Funktion oder eine logarithmische Funktion oder eine periodische Funktion oder eine Superposition der genannten Funktion oder enthält Anteile einer dieser Funktionen.

Gemäß einer weiteren vorteilhaften Ausgestaltungen weisen alle Schichten des Übergitters eine gleiche Dicke auf. Gemäß einer weiteren vorteilhaften Ausgestaltungen weisen Schichten unterschiedlichen Typs unterschiedliche Dicken auf.

Gemäß vorteilhafter Ausgestaltungen des optoelektronischen Bauelements istdas mindestens eine Element, dessen Gehalt in zumindest zwei Schichten des gleichen Typs unterschiedlich ist, Al. Dabei steigt der Al-Gehalt innerhalb des Übergitters der Halbleiter-Schichtstruktur mit wachsendem Abstand von der optisch aktiven Schicht an oder fällt ab. Bei einem optoelektronischen Bauelement mit optisch aktiver Schicht kann ein hoher Al-Gehalt einer unmittelbar oder mittelbar an die aktive Schicht angrenzenden Schicht des Übergitters zu nachteiligen Verspannungen in der aktiven Schicht führen, durch die die Quanteneffizienz dieser Schicht verringert wird. Durch einen zur aktiven Schicht hin abfallenden Al-Gehalt innerhalb des Übergitters können Verluste durch eine geringere Quanteneffizienz verringert werden. Ein höherer Al-Gehalt führt dagegen zu einer größeren Bandlücke und damit zu einer geringeren optischen Absorption einer Schicht. Da in Richtung der aktiven Schicht die Intensität einer von der aktiven Schicht erzeugten Strahlung ansteigt, kann ein zur aktiven Schicht hin ansteigender Al-Gehalt innerhalb des Übergitters folglich bezüglich optischer Absorptionsverluste vorteilhaft sein.

Gemäß weiterer vorteilhafter Ausgestaltungen ist das optoelektronische Bauelement eine Leuchtdiode oder eine Laserdiode.

Weitere vorteilhafte Ausgestaltungen der Erfindung ergeben sich aus den im folgenden in Verbindung mit den in den Figuren beschriebenen Ausführungs- und Vergleichsbeispielen.

Es zeigen:
- Figur 1: eine Querschnittszeichnung eines optoelektronischen Bauelements mit einer erfindungsgemäßen Halbleiter-Schichtstruktur mit Übergitter und die
- Figuren 2-5: schematische Darstellungen des Gehalts eines oder verschiedener Elemente abhängig von einer vertikalen Position in einem Übergitter bei verschiedenen Ausführungs- und Vergleichsbeispielen einer Halbleiter-Schichtstruktur mit Übergitter.

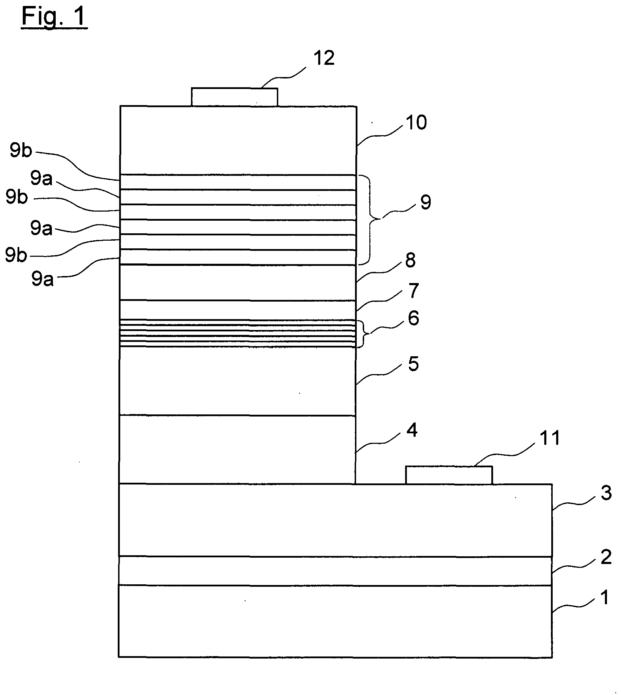

In Figur 1 ist die Schichtenfolge einer Halbleiter-Schichtstruktur eines optoelektronischen Bauelements mit einem Übergitter im Querschnitt schematisch dargestellt. Auf einem Substrat 1 sind eine Anpassungsschicht 2 und folgend eine n-dotierte Kontaktschicht 3 aufgewachsen. Zur einfacheren Darstellung wird der Dotierungstyp von Schichten im Folgenden durch Voranstellen des Buchstabens n oder p angegeben, also z.B. n-Kontaktschicht 3.

Auf der n-Kontaktschicht 3 befindet sich eine n-Mantelschicht 4 und eine n-Wellenleiterschicht 5. Auf diese ist eine aktive Schicht 6 aufgebracht, anschließend eine Barriereschicht 7 sowie eine p-Wellenleiterschicht 8. Es folgt eine p-Mantelschicht, die als Übergitter 9 ausgeführt ist. Das Übergitter 9 weist die alternierend gestapelten Schichten 9a eines ersten Typs a und Schichten 9b eines zweiten Typs b auf.

Auf das Übergitter 9 ist eine p-Kontaktschicht 10 aufgewachsen. Im rechten Bereich ist die Schichtenfolge durch Abätzen bis auf eine dem Substrat abgewandte Fläche der n-Kontaktschicht 3 abgetragen, beziehungsweise wurde in diesem Bereich durch Maskierung erst gar nicht aufgebaut. Auf der freiliegenden Fläche der n-Kontaktschicht 3 ist ein n-Kontakt 11 aufgebracht. Auf der p-Kontaktschicht 10 befindet sich ein p-Kontakt 12.

Die Figur 1 ist als schematische Zeichnung zu verstehen. Insbesondere sind die gezeigten Schichtdicken nicht maßstabsgetreu.

Das in Figur 1 gezeigte Bauelement stellt eine Doppel-Heterostruktur Laserdiode dar. Im Folgenden ist beispielhaft eine Realisierung im InₓAl_{y}Ga_{1-x-y}N Materialsystem näher beschrieben. In einem solchen Fall kann Saphir als Substrat 1 Verwendung finden und n-dotiertes GaN als n-Kontaktschicht 3 eingesetzt werden. Zur n-Dotierung der GaN-Schicht wird vorzugsweise Silizium (Si) eingesetzt. Als Anpassungsschicht 2 ist typischerweise eine Aluminiumnitrid (AlN) Schicht zwischen dem Saphir-Substrat 1 und der GaN n-Kontaktschicht 3 zur Anpassung der unterschiedlichen Gitterkonstanten dieser Schicht vorgesehen.

Analog kann die p-Kontaktschicht 10 durch eine mit Magnesium (Mg) p-dotierte GaN-Schicht realisiert werden, wobei eine durch die Magnesiumstörstellen induzierte Löcherleitung nach Aufwachsen der Schicht in bekannter Weise aktiviert wird, z.B. durch Elektronenbestrahlung oder thermische Behandlung. Als n- oder p-Kontakte 11 bzw. 12 können Elektroden, z.B. aus Aluminium oder Nickel, auf die entsprechenden n- oder p-Kontaktschichten 3 bzw. 10 aufgedampft werden. Das zu dem Zweck erforderliche Freilegen der n-Kontaktschicht 3 kann beispielsweise durch einen Trockenätzprozess in Chlorgas oder durch Argon-Ionen-Sputtern erfolgen.

Alternativ kann statt eines nicht leitenden Substrats 1 ein leitendes Substrat, wie z.B. Galliumnitrid (GaN) oder Siliziumkarbid (SiC), eingesetzt werden. In einem solchen Fall kann die n-Kontaktschicht 3 und gegebenenfalls, z.B. beim Einsatz von GaN, die Anpassungsschicht 2 entfallen. Der n-Kontakt 11 kann dann gegenüber dem p-Kontakt 12 auf der der Halbleiter-Schichtstruktur abgewandten Seite des Substrats aufgebracht werden, so dass eine vertikal leitende Halbleiter-Schichtstruktur gebildet wird.

Ohne Einschränkung ist in der Figur 1 ein Ausführungsbeispiel gezeigt, bei dem zunächst n-dotierte Schichten auf das Substrat 1 aufgebracht sind. Eine Anordnung, bei der p-dotierte Schichten näher am Substrat 1 angeordnet sind als die n-dotierten Schichten, ist ebenso möglich. Die beiden Ausführungen können bezüglich der Ladungsträgerinjektion in die Halbleiter-Schichtstruktur unterschiedliche Eigenschaften aufweisen. Abhängig von den gewünschten Eigenschaften kann sich jede der Ausführungen im Einzelfall als vorteilhaft erweisen.

Die aktive Schicht 6 kann z.B. eine Einfach- oder Mehrfach-Quantenschichtstruktur sein, bei der Indium-Galliumnitrid (InGaN)-Quantenschichten abwechselnd mit AlGaN-Barriereschichten gestapelt sind.

Als Quantenschicht ist im Rahmen der Erfindung eine Schicht zu verstehen, die so dimensioniert oder strukturiert ist, dass eine für die Strahlungserzeugung wesentliche Quantisierung der Ladungsträger-Energieniveaus, zum Beispiel durch Einschluss (confinement), auftritt. Insbesondere beinhaltet die Bezeichnung Quantenschicht keine Angabe oder Einschränkung über die Dimensionalität der Quantisierung. Die Quantenschicht kann einen zweidimensionalen Quantentopf bilden oder strukturelle Elemente mit niedrigerer Dimensionalität wie Quantendrähte oder Quantenpunkte oder Kombinationen dieser Strukturen enthalten.

Darüber hinaus ist auch der Einsatz einer Fotolumineszenzaktiven Schicht, z. B. einer Fremdatom-dotierten InGaN-Schicht als aktive Schicht 6 denkbar.

Die die aktive Schicht 6 umgebenden Schichten (n- und p-Wellenleiterschichten 5 bzw. 8, n-Mantelschicht 4, Übergitter 9 als p-Mantelschicht und Barriereschicht 7) haben eine größere Bandlücke als die aktiven Schicht 6. Dieses bewirkt eine Konzentration oder eine Eingrenzung, auch confinement genannt, von Ladungsträgern und/oder Feldern auf die aktive Schicht 6. Die Anzahl der zu diesem Zweck vorgesehenen Schichten ist nicht auf die in der Figur gezeigte Anzahl von fünf Schichten festgelegt, sondern prinzipiell beliebig.

Weiterhin bilden die die aktive Schicht 6 umgebenden Schichten einen Wellenleiter für die in der aktiven Schicht 6 erzeugte Strahlung. Gute Wellenführungseigenschaften werden erreicht, wenn der Brechungsindex in einer Richtung senkrecht zur aktiven Schicht 6 von dieser aus nach außen abnimmt. Da GaN einen höheren Brechungsindex aufweist als AlGaN, sind die näher an der aktiven Schicht 6 angeordneten n- und p-Wellenleiterschichten 5 bzw. 8 im Ausführungsbeispiel als GaN-Schichten ausgeführt. Die n-Mantelschicht 4 und das Übergitter 9 als p-Mantelschicht sind bevorzugt aluminiumhaltig.

Auf der dem Substrat 1 zugewandten Seite der aktiven Schicht 6 (n-dotierte Seite) kann die Wellenleiterschicht 5 beispielsweise als eine Si-dotierte GaN-Schicht ausgeführt sein und die Mantelschicht 4 als eine Si-dotierte AlGaN-Schicht. Auf der dem Substrat 1 abgewandten Seite der aktiven Schicht 6 (p-dotierte Seite) kann analog eine Magnesium (Mg)-dotierte GaN-Schicht als Wellenleiterschicht 8 eingesetzt werden. Um eine direkte Rekombination von Elektronen, die aus der aktiven Schicht 6 in die Wellenleiterschicht 8 diffundieren, mit den dort befindlichen Löchern zu verhindern, ist zwischen beiden Schichten zusätzlich die Barriereschicht 7 vorgesehen. Diese kann durch eine bevorzugt hoch p-dotierte AlGaN-Schicht realisiert sein, die typischerweise deutlich dünner als die n- und p-Wellenleiterschichten 5 bzw. 8, die n-Mantelschicht 4 oder das Übergitter 9 ausgeführt ist.

Die p-seitige Mantelschicht wird durch das Übergitter 9 realisiert.

Im Ausführungsbeispiel der Figur 1 ist das Übergitter 9 durch abwechselnd angeordnete Schichten 9a des ersten Typs a und Schichten 9b des zweiten Typs b gebildet. Beispielhaft und wegen einer übersichtlicheren Darstellung sind in der Figur nur je 3 Schichten der zwei verschiedenen Typen a und b gezeigt. In tatsächlichen Umsetzungen der Erfindung weist das Übergitter üblicherweise eine größere Anzahl von Schichten auf, beispielsweise mehrere zehn bis einige hundert Schichten jeden Typs. Typische Schichtdicken für eine einzelne Schicht des Übergitters 9 liegen im Bereich von wenigen nm bis hin zu mehreren zehn nm, z.B. zwischen 2nm und 50 nm und bevorzugt zwischen 3 nm und 10 nm. Schichten gleichen Typs weisen nominell (d.h. im Rahmen der Genauigkeit der Schichtdickenkontrolle während oder nach dem Wachstumsprozess) die gleiche Schichtdicke auf. Die Schichten 9a des ersten Typs a und die Schichten 9b des zweiten Typs b können sich in ihrer Dicke jedoch voneinander unterscheiden (asymmetrisches Übergitter) oder auch gleich sein (symmetrisches Übergitter).

Im GaN-basierten Materialsystem kann das Übergitter 9 als p-Mantelschicht z.B. aus alternierenden Mg-dotierten GaN-Schichten und Mg-dotierten AlGaN-Schichten bestehen. Aufgrund der hohen Aktivierungsenergie der Mg-Dotieratome ist die elektrische Leitfähigkeit von p-dotierten Schichten gering. Zudem hat AlGaN eine größere Bandlücke als GaN und weist aufgrund einer geringeren Dotiereffizienz eine geringere Leitfähigkeit auf. Die Dotiereffizienz gibt an, in welcher Konzentration Dotierstoffe überhaupt vom Material aufgenommen werden und welcher Anteil aufgenommener Dotieratome prinzipiell (d.h. unbeachtlich temperaturbedingter Besetzungseffekte) überhaupt zur Leitfähigkeit beitragen kann. Die Dotiereffizienz ist unter anderem davon abhängig, welche Gitter- oder Zwischengitterplätze die Dotieratome einnehmen.

Durch den Einsatz höher und effizienter dotierbarer und somit leitfähigerer GaN-Schichten kann das Übergitter 9 verglichen mit einer p-dotierten reinen AlGaN-Mantelschicht eine erhöhte Leitfähigkeit bei effektiv gleichem Brechungsindex aufweisen.

Ein effektiv gleicher Brechungsindex kann durch einen erhöhten Aluminiumgehalt der im Übergitter 9 eingesetzten AlGaN-Schichten verglichen mit der reinen AlGaN-Mantelschicht erreicht werden.

Statt eines GaN-/AlGaN-Übergitters 9 ist ebenso ein Übergitter 9 denkbar, in dem AlₓGa₁₋ₓN/Al_{y}Ga_{1-y}N-Schichten mit 0≤x,y≤1 und x≠y abwechselnd gestapelt sind. Ebenfalls ist der Einsatz von In statt Al in allen oder einigen Schichten des Übergitters 9 möglich. Auch sind Übergitter 9 denkbar, bei denen drei oder mehr verschiedenen Schichttypen alternierend gestapelt sind.

Weiterhin ist auch für die n-dotierte AlGaN-Mantelschicht 4 der Einsatz eines Übergitters denkbar. Aufgrund der im Allgemeinen höheren Leitfähigkeit von n-dotierten Schichten liegt in diesem Fall ein Vorteil nicht primär in einer erhöhten vertikalen Leitfähigkeit. Vorteile ergeben sich jedoch durch eine mögliche Verringerung von Verspannungen, die in der aktiven Schicht 6 induziert werden. Ein weiterer Vorteil, der insbesondere bei seitlicher Stromeinbringung zum Tragen kommt, liegt in der erhöhten lateralen Stromleitfähigkeit eines Übergitters begründet.

Das Übergitter 9 kann, z.B. aufgrund seines Gehalts an Al, Verspannungen in der aktiven Schicht 6 induzieren. Diese Verspannungen können durch die zwischen dem Übergitter 9 und der aktiven Schicht 6 liegende GaN-Wellenleiterschicht 8 zwar abgemindert werden, jedoch nicht unbedingt in ausreichendem Maße. Dieses gilt insbesondere, da die Dicke der GaN-Wellenleiterschicht 8, von der eine Verringerung der induzierten Verspannungen abhängt, aufgrund der Anforderungen an die optischen Wellenleitereigenschaften vorgegeben ist.

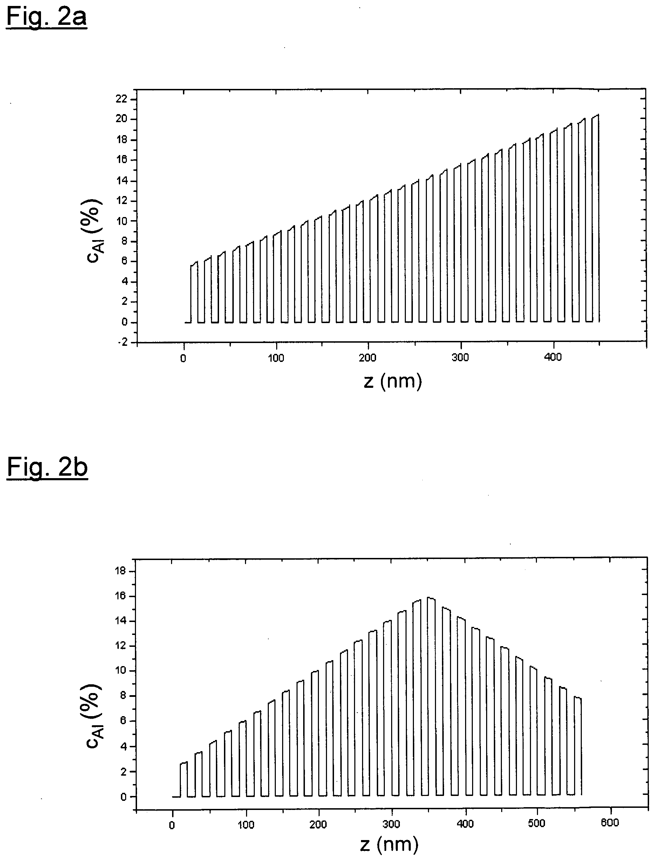

Erfindungsgemäß ist der Gehalt an Al und auch In, das ebenfalls Auswirkungen auf induzierte Verspannungen in der aktiven Schicht 6 hat, innerhalb der Schichten zumindest einen Typs im Übergitter 9 nicht konstant, wodurch das Übergitter 9 in bestmöglicher Weise an die gegenläufigen Anforderungen von guter Wellenleitung und geringer induzierter Verspannung angepasst werden kann. Detaillierte Beschreibungen von entsprechenden Übergittern, bei denen der Gehalt an zumindest einem Element (hier Al und/oder In) innerhalb Schichten einer oder mehrerer Typen im Übergitters variiert, werden im Folgenden im Zusammenhang mit den Ausführungs- und Vergleichsbeispielen der Figuren 2 bis 5 gegeben.

In den Figuren 2 bis 5 ist jeweils zu verschiedenen Ausführungs- und Vergleichsbeispielen eines Übergitters je ein Diagramm gezeigt, in dem der Al-Gehalt c_{Al} und ggf. der In-Gehalt c_{In} in Prozent (Ordinate) abhängig von einer vertikalen Position z innerhalb des Übergitters einer Halbleiter-Schichtstruktur (Abszisse) angegeben ist. Als Nullpunkt der vertikalen Position z innerhalb des Übergitters ist die Seite des Übergitters gewählt, die einer aktiven Schicht zugewandt ist. Die aktive Schicht liegt folglich links vom dargestellten Bereich des Übergitters bei negativen Werten der vertikalen Position z.

Das Übergitter wird jeweils durch eine Vielzahl alternierend gestapelter Schichten verschiedener Typen a, b und ggf. auch c, d gebildet, wobei per Definition die bei z=0 beginnende, der aktiven Schicht am nächsten liegende Schicht des Übergitters vom Typ a sei.

In Figur 2a ist ein Übergitter einer Halbleiter-Schichtstruktur gemäß einem Vergleichsbeispiel dargestellt, bei dem Schichten zwei verschiedener Typen a, b alternierend gestapelt sind. Von jedem Schichttyp a, b sind 30 Schichten mit einer Schichtdicke von je 7.5 nm vorgesehen, so dass das Übergitter insgesamt 450 nm dick ist. Die Schichten des Typs a sind GaN-Schichten. Die Schichten des Typs b sind AlGaN-Schichten, wobei der Al-Gehalt c_{Al} dieser Schichten von etwa 5% bis 20% von Schicht zu Schicht linear ansteigt und wobei der Al-Gehalt c_{Al} innerhalb der einzelnen AlGaN-Schichten gradiert ist. Der mittlere Al-Gehalt der AlGaN-Schichten beträgt somit 12.5%. Die der aktiven Schicht zugewandte Schicht weist dabei den geringsten Al-Gehalt c_{Al} auf. Gegenüber einem GaN/AlGaN-Übergitter, bei dem die AlGaN-Schichten einen mittleren Al-Gehalt von 12.5% haben, induziert das Übergitter der Figur 2a weniger Verspannungen in der aktiven Schicht, da sich die Gitterstruktur und - konstanten im Übergitter mit dem zur aktiven Schicht hin abfallenden Al-Gehalt vorteilhaft ändern. Ein zur aktiven Schicht hin abfallender Al-Gehalt kann weiterhin bevorzugt sein, weil Übergangsbarrieren zur aktiven Schicht erniedrigt werden und so ein Heterostrukturübergang weniger stark ausfällt. Ein gradierter Al-Gehalt innerhalb einer Schicht kann den leitfähigkeitserhöhenden Effekt eines Übergitters unterstützen.

Ein weiterer Vorteil eines Übergitters, bei dem der Al-Gehalt c_{Al} sich linear oder, allgemeiner, umkehrbar eindeutig mit der Position einer Schicht im Übergitter verändert, ergibt sich im Herstellungsprozess eines Bauelements. Zur Aufbringung von Kontakten oder zur Wellenführung ist häufig das Einbringen von Gräben (ridges) in eine Halbleiterstruktur erforderlich. Um eine definierte Tiefe der Gräben sicherzustellen, wird in manchen Materialsystemen nasschemisches Ätzen in Verbindung mit so genannten Ätzstoppschichten eingesetzt. Beim dem gegenüber nasschemischen Ätzprozessen resistenten AlGaN-Materialsystem kann jedoch üblicherweise nur das wenig material-selektive Trockenätzen benutzt werden. Wenn während des Ätzprozesses der Al-Gehalt des abgetragenen Materials gemessen wird, kann über den Zusammenhang zwischen Al-Gehalt c_{Al} der Schichten im Übergitter und deren Position innerhalb des Übergitters eine in-situ Tiefenbestimmung erfolgen. Eine Messung des Al-Gehalt des abgetragenen Materials kann beispielsweise massenspektometrisch erfolgen.

Figur 2b zeigt ein Ausführungsbeispiel eines GaN/AlGaN-Übergitters, bei dem der Al-Gehalt c_{Al} in den AlGaN-Schichten im Inneren des Übergitters einen Maximalwert von etwa 17% aufweist und zu beiden Seiten abfällt. Auf diese Weise werden Verspannungen zu beiden Seiten des Übergitters verringert, wobei im gezeigten Beispiel der Maximalwert nicht genau in der Mitte des Übergitters erreicht wird und die einer aktiven Schicht nächstliegenden Schicht einen geringeren Al-Gehalt c_{Al} aufweist, als die von der aktiven Schicht am weitesten entfernte Schicht.

Verallgemeinert kann der Verlauf des Al-Gehalts c_{Al} innerhalb eines Übergitters durch eine (Hüllkurven-) Funktion beschrieben werden, die den Al-Gehalt c_{Al} einer Schicht abhängig von der Position der Schicht angibt. Dabei kann entweder eine gemeinsame Funktion für alle Schichtentypen a, b, usw. vorgegeben sein, oder es kann für jeden Schichtentyp eine eigene Funktion vorgegeben sein. Prinzipiell ist dabei jeder beliebige, z.B. auch nichtlineare, Funktionsverlauf möglich.

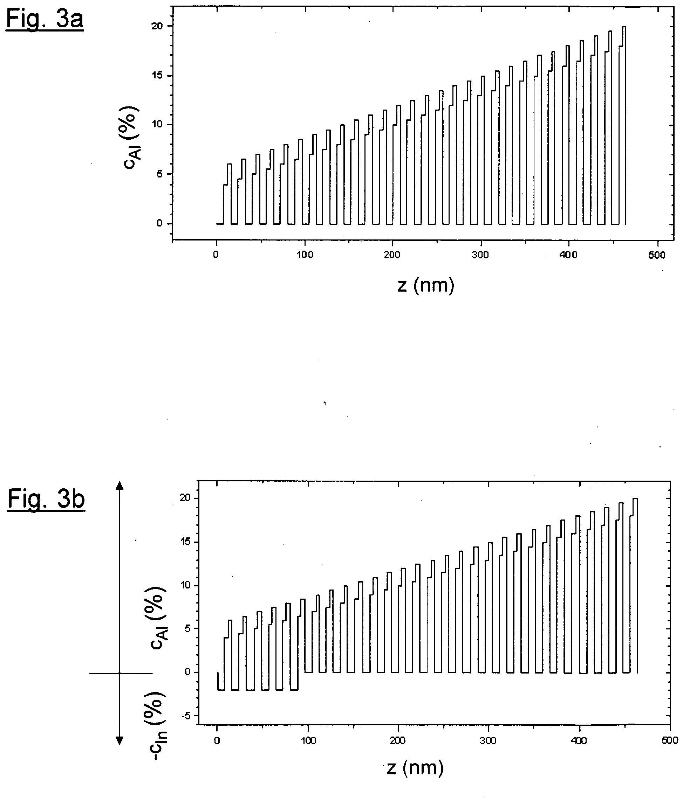

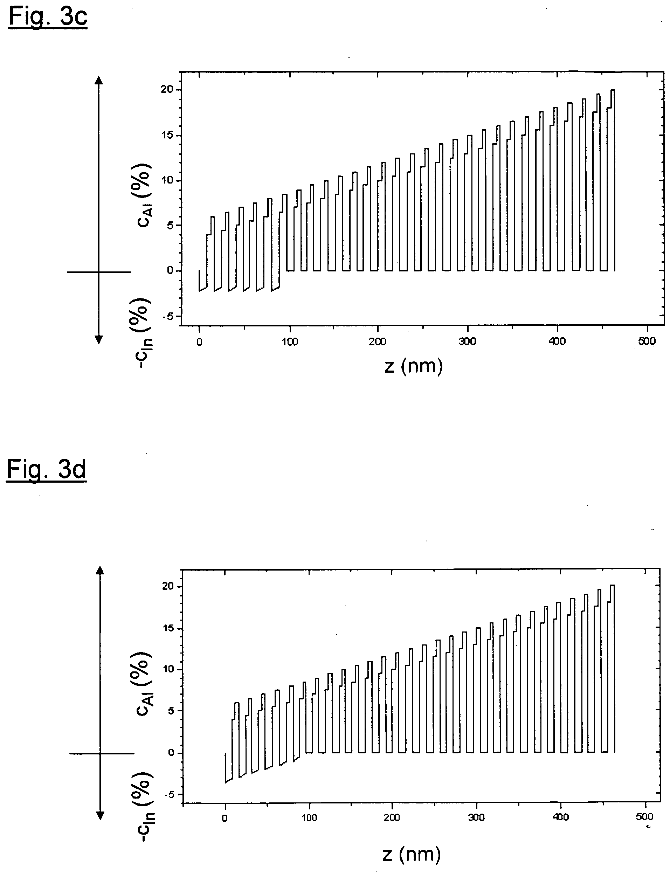

In Figur 3 sind Vergleichsbeispiele von Übergittern einer Halbleiter-Schichtstruktur dargestellt, bei denen Schichten drei verschiedener Typen a, b und c alternierend gestapelt sind.

Die Schichten vom Typ a sind im Beispiel von Figur 3a GaN-Schichten mit konstanter Zusammensetzung über das Übergitter. Die Schichten der Schichttypen b und c sind AlGaN-Schichten, deren Al-Gehalt c_{Al} innerhalb des Übergitters variiert. Sowohl für Schichten des Typs b als auch für Schichten des Typs c steigt der Al-Gehalt c_{Al} linear mit wachsender vertikaler Position z der Schicht, jedoch weist eine Schicht vom Typ c jeweils 2% mehr Al auf, als die zu ihr direkt benachbarte Schicht vom Typ b. Schichten vom Typ b und c sind zudem nur halb so dick wie Schichten vom Typ a. In gewisser Weise kann die Struktur auch als GaN/AlGaN-Übergitter mit nur zwei Schichttypen betrachtet werden, von denen die AlGaN-Schichten mit einer Stufenfunktion gradiert sind. Wie weiter oben bereits erwähnt, kann ein gradierter Al-Gehalt innerhalb einer Schicht den leitfähigkeitserhöhenden Effekt eines Übergitters unterstützen.

Bei den in den Figuren 3b-d gezeigten Beispielen sind die AlGaN-Schichten vom Typ b und c ebenso ausgeführt wie im Beispiel von Figur 3a. Als Schichten vom Typ a sind jedoch InGaN-Schichten mit variablem In-Gehalt c_{In} vorgesehen. In den Beispielen von Figur 3b und 3c folgt der In-Gehalt c_{In} einer Stufenfunktion, im ersten Fall mit konstantem In-Gehalt innerhalb einer Schicht, im zweiten Fall mit gradiertem In-Gehalt. In dem Beispiel von Figur 3d nimmt der In-Gehalt c_{In} innerhalb von 6 Schichten linear ab und ist für die übrigen Schichten Null. Der Einsatz von InGaN-Schichten statt reiner GaN-Schichten kann einerseits zur Verringerung von in der aktiven Schicht induzierten Verspannungen führen, aber andererseits die Wellenleitung durch das Übergitter verschlechtern, da ein höherer In-Gehalt den Brechungsindex des Übergitters erhöht, was zu einem geringeren Brechungsindexkontrast gegenüber einer angrenzenden Wellenleiterschicht führt. Durch den nicht konstanten, in Richtung der aktiven Schicht größeren In-Gehalt c_{In} werden die positiven Auswirkungen von InGaN-Schichten im Übergitter gegenüber den nachteiligen Effekten verstärkt.

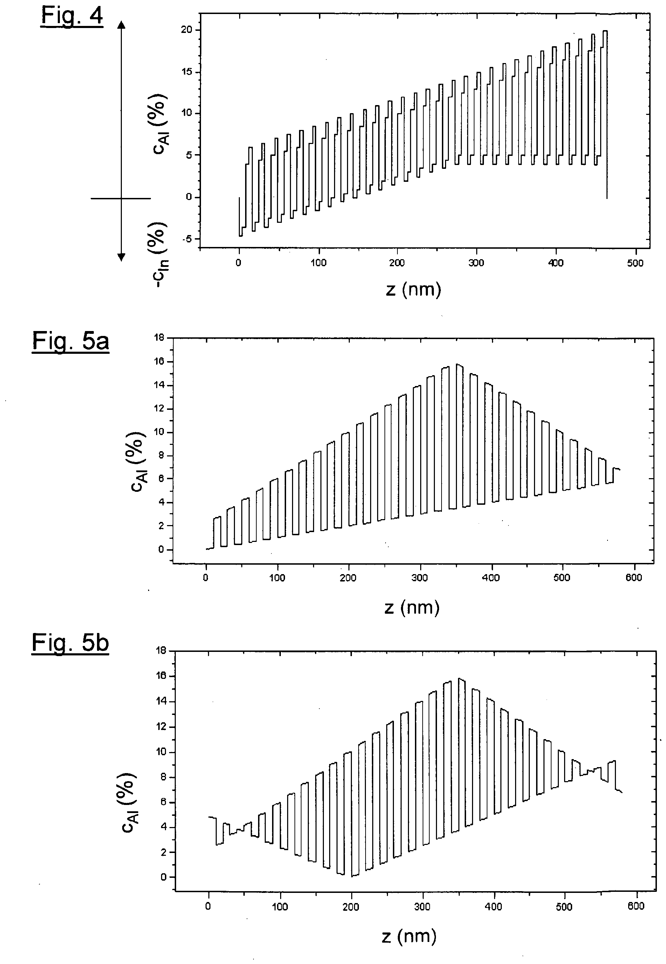

Figur 4 zeigt ein Vergleichsbeispiel eines Übergitters einer Halbleiter-Schichtstruktur, bei dem Schichten vier verschiedener Typen a, b, c und d alternierend gestapelt sind. Die Schichten vom c und d sind, ähnlich den Schichten b und c aus Figur 3, AlGaN-Schichten, deren Al-Gehalt c_{Al} innerhalb des Übergitters innerhalb der Schichten eines Typs linear ansteigt, wobei der Al-Gehalt c_{Al} einer Schicht vom Typ d jeweils um etwa 2% höher ist, als der der benachbarten Schicht vom Typ c. Die Schichten vom Typ a und b sind Schichten der Zusammensetzung InₓAl_{y}Ga_{z}N_{(1-x-y-z)}, mit x=0 wenn y>0 und y=0 wenn x>0. In und Al kommen in diesen Ausführungsbeispielen folglich nicht gleichzeitig in einer Schicht vor. Grundsätzlich ist ein Einsatz von Schichten, die In und Al enthalten, natürlich möglich. Der In-Gehalt c_{In}, d.h. der Koeffizient x, fällt zunächst in den ersten 9 Schichten des Typs a und den ersten 8 Schichten des Typs b (von einer aktiven Schicht aus gerechnet) linear ab und ist bei den folgenden Schichten Null. Der Al-Gehalt c_{Al}, d.h. der Koeffizient y, ist dagegen in den ersten 8 bzw. 9 Schichten Null (z zwischen 0 und 130 nm), steigt dann für die folgenden mittleren Schichten (z zwischen 130 und 270 nm) linear an, um für die restlichen Schichten (z>270 nm) auf einem konstanten Niveau zu bleiben. Dabei ist für jede Schicht vom Typ a der In-Gehalt c_{In} größer und der Al-Gehalt c_{Al} kleiner als für die jeweilige benachbarte Schicht vom Typ b. In gewisser Weise kann die Struktur auch als Übergitter mit nur zwei Schichttypen betrachtet werden, von denen die AlGaN-Schichten mit einer Stufenfunktion gradiert sind. Die Vorteile, die ein geringer Al-Gehalt c_{Al} und ein erhöhter In-Gehalt c_{In} in Schichten, die unmittelbar oder mittelbar der aktiven Schicht benachbart sind, bezüglich induzierter Verspannung haben, werden in dieser Ausführungsform mit den positiven Auswirkungen eines (stufenweise) gradierten Al-Gehalt auf die Leitfähigkeit des Übergitters kombiniert.

In Figur 5 sind Ausführungsbeispiele von AlGaN/AlGaN-Übergittern einer Halbleiter-Schichtstruktur dargestellt. Die Schichten beider Typen a und b sind AlGaN-Schichten, bei denen der Al-Gehalt c_{Al} innerhalb des Übergitters variiert. Der Al-Gehalt c_{Al} abhängig von der vertikalen Position z einer Schicht vom Typ a sei durch eine erste Funktion beschrieben, der Al-Gehalt c_{Al} einer Schicht vom Typ b sei durch eine zweite Funktion gegeben. Für alle zwei Beispiele in Figur 5 ist die erste Funktion ungleich der zweiten. Direkt benachbarte Schichten unterscheiden sich somit in ihrem Al-Gehalt c_{Al} und somit ihrer Zusammensetzung. Das bedeutet jedoch nicht, dass eine Schicht des Typs a nicht die gleiche Zusammensetzung aufweisen kann wie eine Schicht des Typs b.

Im Beispiel in Figur 5a ist die erste Funktion eine mit der vertikalen Position z linear ansteigende Funktion. Die zweite Funktion weist zunächst einen linearen Anstieg bis zu einem Maximum bei etwa z=350 nm auf und fällt bei größeren Werten von z wiederum linear ab. Bei dem Beispiel in Figur 5b weisen beide Funktionen linear ansteigende und linear abfallende Bereiche auf, wobei die Steigungen der Funktionen und die Positionen des Maximums (Typ b) und Minimums (Typ a) des Al-Gehaltes c_{Al} bei beiden Funktionen unterschiedlich sind.

Bei den Ausführungsbeispielen der Figur 5 wird durch den bei beiden Schichttypen a und b variierenden Al-Gehalt c_{Al} ein Übergitter geschaffen, das durch einen hohen mittleren Al-Gehalt eine gute Wellenführung ermöglicht und dennoch durch den zur aktiven Schicht hin abfallenden Al-Gehalt c_{Al} Verspannungen auf die aktive Schicht vertretbar gering hält.

## Patentansprüche

1. Optoelektronisches Bauelement, das eine aktive Schicht (6) aufweist, wobei
- die aktive Schicht (6) zwischen Wellenleiterschichten (5, 8) angeordnet ist,
- zwischen der aktiven Schicht (6) und einer der Wellenleiterschichten (8) eine Barriereschicht (7) angeordnet ist,
- jeweils auf der der aktiven Schicht abgewandten Seite der Wellenleiterschichten eine Mantelschicht angeordnet ist, zumindest eine Mantelschicht eine Halbleiter-Schichtstruktur umfasst, die ein Übergitter (9) aus gestapelten Schichten (9a, 9b) eines ersten (a) und mindestens eines zweiten Typs (b) umfasst,
- die Schichten (9a, 9b) des ersten Typs (a) und des mindestens einen zweiten Typs (b) alternierend gestapelte InₓAl_{y}Ga_{1-x-y}N- und In_{w}Al_{z}Ga_{1-w-z}N-Schichten mit 0 ≤ x, y, w, z ≤ 1 und x + y ≤ 1 und w + z ≤ 1 sind,
- im Übergitter (9) benachbarte Schichten unterschiedlichen Typs sich in der Zusammensetzung in mindestens einem Element unterscheiden,
- im Übergitter (9) zumindest zwei Schichten eines gleichen Typs einen unterschiedlichen Gehalt (c_{Al}, c_{In}) an dem mindestens einen Element aufweisen,
- der Gehalt (c_{Al}, c_{In}) an dem mindestens einen Element der Schichten (9a, 9b) zumindest eines Typs (a, b) innerhalb des Übergitters (9) gradiert ist,
- die Schichten (9a, 9b) des Übergitters (9) Dotierstoffe in vorgegebenen Konzentrationen enthalten, wobei das Übergitter (9) Schichten (9a, 9b) aufweist, die mit Mg in unterschiedlichen Konzentrationen dotiert sind, und
- der Gehalt (c_{Al}, c_{In}) an dem mindestens einen Element im Inneren des Übergitters einen Maximalwert hat, der nicht in der Mitte des Übergitters liegt.

2. Optoelektronisches Bauelement nach Anspruch 1, bei dem einzelnen Schichten des Übergitters (9) eine vertikale Position (z) innerhalb der Halbleiter-Schichtstruktur zugeordnet ist, und der Gehalt (c_{Al}, c_{In}) des mindestens einen Elements in einer Schicht in vorgegebener Weise abhängig von ihrer vertikalen Position (z) innerhalb der Halbleiter-Schichtstruktur ist.

3. Optoelektronisches Bauelement nach Anspruch 2, bei dem die Abhängigkeit des Gehalts (c_{Al}, c_{In}) an dem mindestens einen Element von der vertikalen Position (z) für alle Schichten (9a, 9b) des Übergitters (9) durch eine gemeinsame Funktion vorgegeben ist.

4. Optoelektronisches Bauelement nach Anspruch 2, bei dem die Abhängigkeit des Gehalts (c_{Al}, c_{In}) an dem mindestens einen Element von der vertikalen Position (z) für Schichten (9a) des ersten Typs (a) durch eine erste Funktion und für Schichten (9b) des mindestens einen zweiten Typs (b) durch mindestens eine zweite Funktion vorgegeben ist.

5. Optoelektronisches Bauelement nach Anspruch 4, bei dem die erste Funktion eine Stufenfunktion oder eine monoton steigende/fallende Funktion oder eine lineare Funktion oder eine Polynomfunktion oder eine exponentielle Funktion oder eine logarithmische Funktion oder eine periodische Funktion oder eine Superposition der genannten Funktionen ist oder Anteile einer dieser Funktionen enthält.

6. Optoelektronisches Bauelement nach einem der Ansprüche 4 oder 5, bei dem die mindestens eine zweite Funktion eine Stufenfunktion oder eine monoton steigende/fallende Funktion oder eine lineare Funktion oder eine Polynomfunktion oder eine exponentielle Funktion oder eine logarithmische Funktion oder eine periodische Funktion oder eine Superposition der genannten Funktionen ist oder Anteile einer dieser Funktionen enthält.

7. Optoelektronisches Bauelement nach Anspruch 3, bei dem die gemeinsame Funktion eine Stufenfunktion oder eine monoton steigende/fallende Funktion oder eine lineare Funktion oder eine Polynomfunktion oder eine exponentielle Funktion oder eine logarithmische Funktion oder eine periodische Funktion oder eine Superposition der genannten Funktionen ist oder Anteile einer dieser Funktionen enthält.

8. Optoelektronisches Bauelement nach einem der Ansprüche 1 bis 7, bei dem Gehalt (c_{Al}, c_{In}) an dem mindestens einen Element innerhalb einer Schicht (9a, 9b) des Übergitters (9) konstant ist.

9. Optoelektronisches Bauelement nach einem der Ansprüche 1 bis 8, bei dem alle Schichten (9a, 9b) gleiche Dicken aufweisen.

10. Optoelektronisches Bauelement nach einem der Ansprüche 1 bis 8, bei dem Schichten (9a, 9b) unterschiedlichen Typs (a, b) unterschiedliche Dicken aufweisen.

11. Optoelektronisches Bauelement nach einem der vorhergehenden Ansprüche, das eine Leuchtdiode ist.

12. Optoelektronisches Bauelement nach einem der vorhergehenden Ansprüche 1 bis 10, das eine Laserdiode ist.

## Claims

1. Optoelectronic component comprising an active layer (6), wherein
- the active layer (6) is arranged between waveguide layers (5, 8),
- a barrier layer (7) is arranged between the active layer (6) and one of the waveguide layers (8),
- a cladding layer is arranged in each case on that side of the waveguide layers which faces away from the active layer, at least one cladding layer comprises a semiconductor layer structure comprising a superlattice (9) composed of stacked layers (9a, 9b) of a first type (a) and at least one second type (b),
- the layers (9a, 9b) of the first type (a) and of the at least one second type (b) are alternately stacked InₓAl_{y}Ga_{1-x-y}N and In_{w}Al_{z}Ga_{1-w-z}N layers where 0 ≤ x, y, w, z ≤ 1 and x + y ≤ 1 and w + z ≤ 1,
- in the superlattice (9) adjacent layers of different types differ in at least one element in the composition,
- in the superlattice (9) at least two layers of an identical type have a different content (c_{Al}, c_{In}) of the at least one element,
- the content (c_{Al}, c_{In}) of the at least one element of the layers (9a, 9b) of at least one type (a, b) is graded within the superlattice (9),
- the layers (9a, 9b) of the superlattice (9) contain dopants in predefined concentrations, wherein the superlattice (9) comprises layers (9a, 9b) which are doped with Mg in different concentrations, and
- the content (c_{Al}, c_{In}) of the at least one element internally in the superlattice has a maximum value that does not lie in the centre of the superlattice.

2. Optoelectronic component according to Claim 1, wherein individual layers of the superlattice (9) are assigned a vertical position z within the semiconductor layer structure, and the content (c_{Al}, c_{In}) of the at least one element in a layer is dependent on the vertical position (z) thereof within the semiconductor layer structure in a predefined manner.

3. Optoelectronic component according to Claim 2, wherein the dependence of the content (c_{Al}, c_{In}) of the at least one element on the vertical position (z) is predefined by a common function for all layers (9a, 9b) of the superlattice (9).

4. Optoelectronic component according to Claim 2, wherein the dependence of the content (c_{Al}, c_{In}) of the at least one element on the vertical position (z) is predefined by a first function for layers (9a) of the first type (a) and by at least one second function for layers (9b) of the at least one second type (b).

5. Optoelectronic component according to Claim 4, wherein the first function is a step function or a monotonically rising/falling function or a linear function or a polynomial function or an exponential function or a logarithmic function or a periodic function or a superposition of the stated functions or contains portions of one of these functions.

6. Optoelectronic component according to either of Claims 4 and 5, wherein the at least one second function is a step function or a monotonically rising/falling function or a linear function or a polynomial function or an exponential function or a logarithmic function or a periodic function or a superposition of the stated functions or contains portions of one of these functions.

7. Optoelectronic component according to Claim 3, wherein the common function is a step function or a monotonically rising/falling function or a linear function or a polynomial function or an exponential function or a logarithmic function or a periodic function or a superposition of the stated functions or contains portions of one of these functions.

8. Optoelectronic component according to any of Claims 1 to 7, wherein the content (c_{Al}, c_{In}) of the at least one element is constant within a layer (9a, 9b) of the superlattice (9).

9. Optoelectronic component according to any of Claims 1 to 8, wherein all the layers (9a, 9b) have identical thicknesses.

10. Optoelectronic component according to any of Claims 1 to 8, wherein layers (9a, 9b) of different types (a, b) have different thicknesses.

11. Optoelectronic component according to any of the preceding claims, which is a light-emitting diode.

12. Optoelectronic component according to any of the preceding claims 1 to 10, which is a laser diode.

## Revendications

1. Composant optoélectronique qui comporte une couche active (6), dans lequel
- la couche active (6) est disposée entre des couches de guide d'ondes (5, 8),
- une couche barrière (7) est disposée entre la couche active (6) et l'une des couches de guide d'ondes (8),
- une couche de revêtement est respectivement disposée sur le côté des couches de guide d'ondes qui est opposé à la couche active, au moins une couche de revêtement comprend une structure de couche semi-conductrice, qui comprend un super-réseau (9) constitué de couches empilées (9a, 9b) d'un premier (a) et d'au moins un deuxième type (b),
- les couches (9a, 9b) du premier type (a) et de l'au moins un deuxième type (b) sont des couches empilées de manière alternée d'InₓAl_{y}Ga_{1-x-y}N et d'In_{w}Al_{z}Ga_{1-w-z}N, avec 0 ≤ x, y, w, z ≤ 1 et x + y ≤ 1 et w + z ≤ 1,
- dans le super-réseau (9) des couches voisines de type différent diffèrent par leur composition en au moins un élément,
- dans le super-réseau (9) au moins deux couches d'un même type présentent une teneur différente (c_{Al}, c_{In}) en l'au moins un élément,
- la teneur (c_{Al}, c_{In}) en l'au moins un élément des couches (9a, 9b) d'au moins un type (a, b) est amenée à varier progressivement à l'intérieur du super-réseau (9),
- les couches (9a, 9b) du super-réseau (9) contiennent des matériaux dopants à des concentrations prédéterminées, dans lequel le super-réseau (9) comporte des couches (9a, 9b) qui sont dopées par du Mg à des concentrations différentes, et
- la teneur (c_{Al}, c_{In}) en l'au moins un élément à l'intérieur du super-réseau présente une valeur maximale qui ne se situe pas au centre du super-réseau.

2. Composant optoélectronique selon la revendication 1, dans lequel une position verticale (z) à l'intérieur de la structure de couche semi-conductrice est associée à des couches individuelles du super-réseau (9), et la teneur (c_{Al}, c_{In}) en l'au moins un élément dans une couche dépend de manière prédéterminée de sa position verticale (z) à l'intérieur de la structure de couche semi-conductrice.

3. Composant optoélectronique selon la revendication 2, dans lequel la dépendance de la teneur (c_{Al}, c_{In}) en l'au moins un élément est prédéterminée par une fonction commune de la position verticale (z) pour toutes les couches (9a, 9b) du super-réseau (9).

4. Composant optoélectronique selon la revendication 2, dans lequel la dépendance de la teneur (c_{Al}, c_{In}) en l'au moins un élément, pour les couches (9a) du premier type (a) est prédéterminée par une première fonction et, pour les couches (9b) de l'au moins un deuxième type (b), est prédéterminée par au moins une deuxième fonction de la position verticale (z).

5. Composant optoélectronique selon la revendication 4, dans lequel la première fonction est une fonction discontinue ou une fonction croissant ou décroissant de manière monotone ou une fonction linéaire ou une fonction polynomiale ou une fonction exponentielle ou une fonction logarithmique ou une fonction périodique ou une superposition desdites fonctions ou contient des parties de l'une desdites fonctions.

6. Composant optoélectronique selon l'une quelconque des revendications 4 ou 5, dans lequel l'au moins une deuxième fonction est une fonction discontinue ou une fonction croissant ou décroissant de manière monotone ou une fonction linéaire ou une fonction polynomiale ou une fonction exponentielle ou une fonction logarithmique ou une fonction périodique ou une superposition desdites fonctions ou contient des parties de l'une desdites fonctions.

7. Composant optoélectronique selon la revendication 3, dans lequel la fonction commune est une fonction discontinue ou une fonction croissant ou décroissant de manière monotone ou une fonction linéaire ou une fonction polynomiale ou une fonction exponentielle ou une fonction logarithmique ou une fonction périodique ou une superposition desdites fonctions ou contient des parties de l'une desdites fonctions.

8. Composant optoélectronique selon l'une quelconque des revendications 1 à 7, dans lequel la teneur (c_{Al}, c_{In}) en l'au moins un élément est constante à l'intérieur de la couche (9a, 9b) du super-réseau (9).

9. Composant optoélectronique selon l'une quelconque des revendications 1 à 8, dans lequel toutes les couches (9a, 9b) ont les mêmes épaisseurs.

10. Composant optoélectronique selon l'une quelconque des revendications 1 à 8, dans lequel des couches (9a, 9b) de type différent (a, b) ont des épaisseurs différentes.

11. Composant optoélectronique selon l'une quelconque des revendications précédentes, qui est une diode électroluminescente.

12. Composant optoélectronique selon l'une quelconque des revendications précédentes 1 à 10, qui est une diode laser.
